Europäisches Patentamt

European Patent Office

Office européen des brevets

(11) Veröffentlichungsnummer: **0 460 531 A1**

## (12) EUROPÄISCHE PATENTANMELDUNG

(21) Anmeldenummer: **91108847.4**

(22) Anmeldetag: **29.05.91**

(51) Int. Cl.⁵: **H01L 29/40**, H01L 23/485

(30) Priorität: **07.06.90 DE 4018297**

(43) Veröffentlichungstag der Anmeldung:
**11.12.91 Patentblatt 91/50**

(84) Benannte Vertragsstaaten:
**DE FR GB**

(71) Anmelder: **SIEMENS AKTIENGESELLSCHAFT**
**Wittelsbacherplatz 2**
**W-8000 München 2(DE)**

(72) Erfinder: **Willer, Josef, Dr.**
**Friedrich-Fröbel-Strasse 62**
**W-8012 Riemerling(DE)**
Erfinder: **Ristow, Dietrich, Dr.**
**Pappelstrasse 35**
**W-8014 Neubiberg(DE)**

(54) **Kontaktmetallisierung auf Halbleitermaterial.**

(57) Kontaktmetallisierung auf Halbleitermaterial (a), insbesondere für GaAs-Transistoren, mit einer den eigentlichen Metall-Halbleiter-Kontakt (f) bildenden Metallschicht (b), mit einer Anschlußmetallisierung (d) zur Kontaktverstärkung und mit einer zwischen diesen Schichten angeordneten Diffusionsbarriere (c), die zum Schutz und zur Erhöhung der Dauerhaftigkeit der Metallschicht (b) auf die Oberfläche dieser Metallschicht (b) bis zu den Kanten reichend aufgebracht ist.

FIG3

EP 0 460 531 A1

Die vorliegende Erfindung betrifft eine Kontaktmetallisierung auf Halbleitermaterial gemäß dem Oberbegriff des Anspruches 1.

Die Zuverlässigkeit bei GaAs-Transistoren ist u. a. dadurch begrenzt, daß sich die elektrischen Eigenschaften der Ohm-Kontakte auf dem GaAs-Kristall im Dauerbetrieb allmählich verschlechtern. Es ist üblich, bei der Herstellung von ohmschen Kontakten auf GaAs eine Schichtfolge aus Nickel, Germanium und Gold nacheinander als Metallkontakt aufzubringen und durch Tempern eine Legierung dieses Metalles mit der GaAs-Schicht an der Oberfläche des Halbleiterbauelementes zu bilden. Die Optimierung der Eigenschaften eines solchen ohmschen Kontaktes erfolgte bislang durch Variieren der Parameter der als Metallkontakt aufgebrachten Metallschicht und des Temperprozesses. Nach dem Einlegieren des Metalles wurde der Kontakt durch weiteres aufgebrachtes Metall verstärkt, um das Bonden (externer Anschluß) bzw. das Verbinden verschiedener Kontakte zu einer Schaltung zu ermöglichen. Gegebenenfalls wurde zur Verbesserung der aus dem Kontaktmetall und der Kontaktverstärkung gebildeten gesamten Kontaktmetallisierung eine ebenfalls aus Metall gebildete Diffusionsbarriere zwischen das Kontaktmetall und die Kontaktverstärkung aufgebracht. Diese Diffusionsbarriere wurde entweder zusammen mit der Kontaktverstärkung aufgebracht, oder es wurden in getrennten Prozeßschritten zunächst die Diffusionsbarriere und danach die Kontaktverstärkung aufgebracht. Bei diesem üblichen Herstellungsverfahren bleibt an der Außenkante der den eigentlichen Kontakt bildenden Metallschicht ein unbedeckter Streifen von z. B. 1 µm Breite wegen Justiertoleranzen.

Die in dieser Weise aufgebrachte Kontaktmetallisierung verändert im Dauerbetrieb - insbesondere bei Leistungsbauelementen und Hochtemperatursensoren - die wesentlichen Kontakteigenschaften. Eine Ursache für diese Verschlechterung liegt darin, daß im Dauerbetrieb durch Kohäsionskräfte das Metall des ohmschen Kontaktes zur Mitte des Kontaktes hin zusammengezogen wird und am Rand des Kontaktes durch eine Verarmung an Metall die kritische Stelle für den Stromübergang zwischen Halbleiter und Metall degradiert. Selbst Dielektrikumsschichten (Passivierung aus z. B. üblicherweise $Si_3 N_4$), die die Metallschicht bedecken, verhindern die Materialwanderung nicht.

Aufgabe der vorliegenden Erfindung ist es, eine Kontaktmetallisierung auf Halbleitermaterial, insbesondere auf GaAs, anzugeben, die einfach herstellbar ist und eine gegenüber herkömmlichen Kontaktmetallisierungen wesentlich geringere Degradation im Dauerbetrieb zeigt.

Diese Aufgabe wird mit der Kontaktmetallisierung mit den Merkmalen des Anspruches 1 gelöst. Weitere Ausgestaltungen ergeben sich aus den Unteransprüchen.

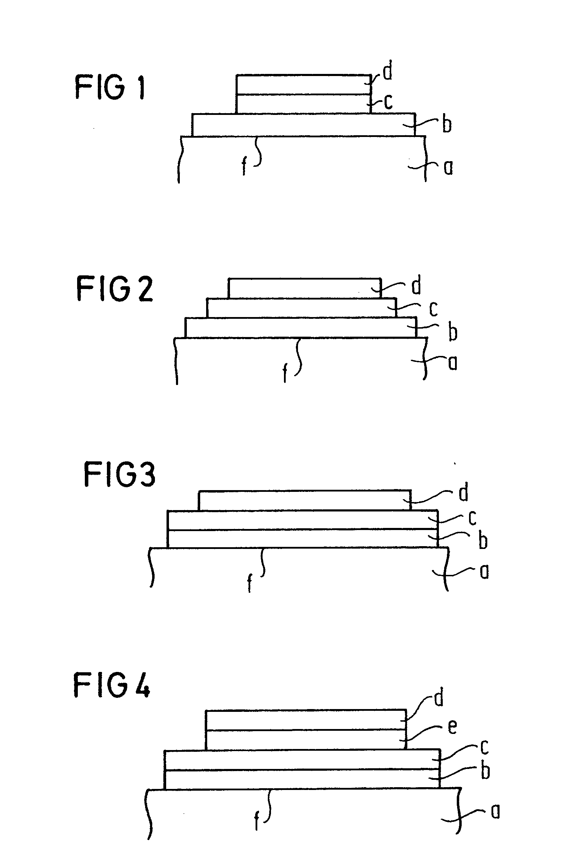

Es folgt eine Beschreibung einer erfindungsgemäßen Kontaktmetallisierung anhand der Figuren 1 bis 4.

Figuren 1 und 2 zeigen Schichtfolgen von Kontaktmetallisierungen im Querschnitt, wie sie dem Stand der Technik entsprechen. Figuren 3 und 4 zeigen Schichtfolgen für die erfindungsgemäße Kontaktmetallisierung im Querschnitt.

Der Erfindung liegt die Erkenntnis zugrunde, daß bei planaren Bauelementen die Qualität der Funktionselemente besonders von der Beschaffenheit der Kanten der jeweils aufgebrachten Materialien abhängt. Die elektrischen Eigenschaften eines Metallkontaktes werden wesentlich durch die Beschaffenheit der Metallkante beeinflußt. Die vorliegende Erfindung gibt einen Metall-Halbleiter-Kontakt an, bei dem eine Stabilisierung der Metallkanten gewährleistet ist. Dadurch wird gleichzeitig das bei den bisher üblichen Kontaktmetallisierungen beobachtete Zusammenziehen der Metallschicht zur Kontaktmitte hin unterbunden. Die erfindungsgemäße Lösung der Aufgabe besteht darin, eine Diffusionsbarriere so anzuordnen, daß die den eigentlichen Metall-Halbleiter-Kontakt bildende Metallschicht bis zu ihrem Rand von dieser Diffusionsbarriere bedeckt wird.

Fig. 1 zeigt eine dem Stand der Technik entsprechende Kontaktmetallisierung auf Halbleitermaterial a, z. B. ein GaAs-Substrat. Darauf ist eine Metallschicht b, die den eigentlichen Metall-Halbleiter-Kontakt f bildet, aufgebracht. Eine Diffusionsbarriere c und eine Anschlußmetallisierung d zur Verstärkung des Kontaktes sind mit kantenkonformem Abschluß darauf aufgebracht. Eine Kontaktmetallisierung, bei der die Diffusionsbarriere c und die Anschlußmetallisierung d in getrennten Schritten aufgetragen sind, ist in Fig. 2 im Querschnitt gezeigt. Die Diffusionsbarriere c und die Anschlußmetallisierung d sind dann nicht notwendig kantenkonform. Die Diffusionsbarriere c ist z. B. Molybdän und verhindert, daß Gallium aus dem Halbleitermaterial in die Anschlußmetallisierung d ausdiffundiert. Mittels der Anschlußmetallisierung d erfolgt die elektrische Verbindung verschiedener Kontaktmetallisierungen zu einer Schaltung z. B. über auf die Oberfläche aufgebrachte Leiterbahnen.

Im Gegensatz dazu ist bei der erfindungsgemäßen Kontaktmetallisierung entsprechend Fig. 3 die Diffusionsbarriere c so aufgebracht, daß die Oberfläche der Metallschicht b bis zu deren Kante hin bedeckt wird. Die Diffusionsbarriere c ist zusammen mit der Metallschicht b, die den eigentlichen Metall-Halbleiter-Kontakt f bildet, strukturiert und diese Schichtfolge aus Metall gemeinsam einlegiert. Auf diese Weise ist der Metall-Halbleiter-Kontakt auch im Hinblick auf Dauerbetrieb bei Leistungsbauelementen optimiert. Die Anschlußmetallisierung d zur wie bisher üblichen Kontaktverstärkung ist auf die Diffusionsbarriere c anschließend aufgebracht. Damit die Schicht der Diffusionsbarriere c beim Legieren möglichst nicht in die dabei ablaufenden chemischen und physikalischen Reaktionen eingreift, sind hochtemperaturfeste Metalle (refractory metals), wie z. B. Mo oder W $B_6$, vorteilhaft.

Eine alternative Ausgestaltung mit einer optionalen weiteren Diffusionsbarriere e ist in Fig. 4 im Querschnitt dargestellt. Diese weitere Diffusionsbarriere e ist zusammen mit der Anschlußmetallisierung d strukturiert. Damit kann die Diffusionsbarriere c kompromißlos auf ihre Funktionsweise als Schutzschicht für die Metallschicht b optimiert werden. Die weitere Diffusionsbarriere e kann im Hinblick auf die eigentliche Funktion als Barriere gegen Ausdiffusion von Halbleitermaterial in die Anschlußmetallisierung d optimiert werden.

## Patentansprüche

1. Kontaktmetallisierung auf Halbleitermaterial (a)
   mit einer einen Metall-Halbleiter-Kontakt (f) bildenden Metallschicht (b),
   mit einer Anschlußmetallisierung (d) und
   mit einer schichtartigen Diffusionsbarriere (c) zwischen der Metallschicht (b) und der Anschlußmetallisierung (d),
   **dadurch gekennzeichnet,**
   daß die Diffusionsbarriere (c) die gesamte Metallschicht (b) bedeckt.

2. Kontaktmetallisierung nach Anspruch 1,
   **dadurch gekennzeichnet,**
   daß der Metall-Halbleiter-Kontakt (f) ein ohmscher Kontakt ist.

3. Kontaktmetallisierung nach Anspruch 1 oder 2,
   **dadurch gekennzeichnet,**
   daß zwischen der Diffusionsbarriere (c) und der Anschlußmetallisierung (d) eine weitere Diffusionsbarriere (e) vorhanden ist.

4. Kontaktmetallisierung nach einem der Ansprüche 1 bis 3,
   **dadurch gekennzeichnet,**
   daß die Metallschicht (b) zusammen mit der Diffusionsbarriere (c) einlegiert ist und
   daß die Diffusionsbarriere (c) hochtemperaturfestes Metall enthält.

5. Kontaktmetallisierung nach einem der Ansprüche 1 bis 4,
   **dadurch gekennzeichnet,**
   daß das Halbleitermaterial GaAs ist.

6. Kontaktmetallisierung nach Anspruch 5,

**dadurch gekennzeichnet,**
daß die Metallschicht (b) eine Schichtfolge aus übereinander Nickel, Germanium und Gold ist und
daß die Diffusionsbarriere (c) Molybdän ist.

FIG 1

FIG 2

FIG 3

FIG 4

Europäisches
Patentamt

EUROPÄISCHER
RECHERCHENBERICHT

Nummer der Anmeldung

EP 91 10 8847

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X,Y | DE-A-3 419 225  (K.K. TOSHIBA) <br> * Seite 6, Zeile 5 - Seite 8, Zeile 6; Figuren 1A, 1B * * Seite 8, Zeile 27 - Seite 10, Zeile 6; Ansprüche 1, 4, 5; Figuren 2A, 2B * * Seite 13, Zeile 31 - Seite 14, Zeile 7 * <br> — — — | 1,2,5,4,6 | H 01 L 29/40 <br> H 01 L 23/485 |
| Y,A | APPLIED PHYSICS LETTERS vol. 48, no. 8, 24 Februar 1986, Seiten 535 - 537; C.L. CHEN et al.: "Low resistance Pd/Ge/Au and Ge/Pd/Au ohmic contacts to n-type GaAs" <br> * Seite 535, rechte Spalte * <br> — — — | 6,1,2,5 | |
| Y,A | EP-A-0 130 416  (IBM) <br> * Seiten 3 - 5; Ansprüche 1, 2; Figuren 1, 2 * <br> — — — | 4,1,2,5,6 | |
| X,A | FR-A-2 620 270  (MITSUBISHI DENKI K.K.) <br> * Seite 1, Zeile 1 - Seite 3, Zeile 10; Ansprüche 1, 2; Figuren 1, 2 * <br> — — — | 1,3,5,4,6 | |
| X,A | EP-A-0 156 551  (SUMITOMO ELECTRIC INDUSTRIES LTD.) <br> * Seite 3, Zeile 8 - Seite 4, Zeile 30; Figur 3 * <br> — — — | 1,2,5,3,4,6 | |
| X,A | PATENT ABSTRACTS OF JAPAN vol. 13, no. 584 (E-866) 22 Dezember 1989, <br> & JP-A-01 246830 (TOSHIBA CORP.) 02 Oktober 1989, <br> * das ganze Dokument * <br> — — — | 1,2,5,6 | |
| X,A | PATENT ABSTRACTS OF JAPAN vol. 9, no. 131 (E-319) 06 Juni 1985, <br> & JP-A-60 016463 (KOGYO GIJUTSUIN) 28 Januar 1985, <br> * das ganze Dokument * <br> — — — | 1,2,5,4,6 | |
| X,A | PATENT ABSTRACTS OF JAPAN vol. 11, no. 77 (E-487) 07 März 1987, <br> & JP-A-61 231760 (SUMITOMO ELECTRIC IND. LTD.) 16 Oktober 1986, <br> * das ganze Dokument * <br> — — — <br> —/— | 1,2,5,4,6 | |

RECHERCHIERTE
SACHGEBIETE (Int. Cl.5)

H 01 L

Der vorliegende Recherchenbericht wurde für alle Patentansprüche erstellt

| Recherchenort | Abschlußdatum der Recherche | Prüfer |
|---|---|---|
| Berlin | 05 August 91 | KLOPFENSTEIN P R |

**Europäisches Patentamt**

# EUROPÄISCHER RECHERCHENBERICHT

Nummer der Anmeldung

## EP 91 10 8847

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X,A | PATENT ABSTRACTS OF JAPAN vol. 8, no. 36 (E-227) 16 Februar 1984,<br>& JP-A-58 192370 (HITACHI SEISAKUSHO K.K.) 09 November 1983,<br>* das ganze Dokument *<br>– – – | 1,2,5,4,6 | |
| X,A | PATENT ABSTRACTS OF JAPAN vol. 8, no. 173 (E-259) 09 August 1984,<br>& JP-A-59 065476 (TOSHIBA K.K.) 13 April 1984,<br>* das ganze Dokument *<br>– – – | 1,2,5,4 | |
| A | PATENT ABSTRACTS OF JAPAN vol. 12, no. 324 (E-653) 02 September 1988,<br>& JP-A-63 090127 (MITSUBISHI ELECTRIC CORP.) 21 April 1988,<br>* das ganze Dokument *<br>– – – | 1,2,4,5,6 | |
| P,A | WO-A-9 104 578  (SECRETARY OF STATE FOR DEFENCE OF U.K.)<br>* Seiten 3 - 4; Ansprüche 1, 2; Figur 1 *<br>– – – – – | 1,2,5,6 | RECHERCHIERTE SACHGEBIETE (Int. Cl.5) |

Der vorliegende Recherchenbericht wurde für alle Patentansprüche erstellt

| Recherchenort | Abschlußdatum der Recherche | Prüfer |
|---|---|---|
| Berlin | 05 August 91 | KLOPFENSTEIN P R |

KATEGORIE DER GENANNTEN DOKUMENTE

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsätze

E: älteres Patentdokument, das jedoch erst am oder nach dem Anmeldedatum veröffentlicht worden ist
D: in der Anmeldung angeführtes Dokument
L: aus anderen Gründen angeführtes Dokument
........................................................................
&: Mitglied der gleichen Patentfamilie, übereinstimmendes Dokument